(19) Europäisches Patentamt
European Patent Office
Office européen des brevets

(11) Veröffentlichungsnummer: **0 224 199**
**B1**

(12) # EUROPÄISCHE PATENTSCHRIFT

(45) Veröffentlichungstag der Patentschrift: **31.01.90**

(51) Int. Cl.⁴: **H01L 21/82**, H01L 29/62

(21) Anmeldenummer: **86116077.8**

(22) Anmeldetag: **20.11.86**

(54) **Verfahren zum Herstellen von p- und n-Kanal-MOS-Transistoren enthaltenden hochintegrierten Schaltungen mit aus einer dotierten Doppelschicht aus Polysilizium und Metallsilizid bestehenden Gateelektroden.**

(30) Priorität: **27.11.85 DE 3541940**

(43) Veröffentlichungstag der Anmeldung:
**03.06.87 Patentblatt 87/23**

(45) Bekanntmachung des Hinweises auf die Patenterteilung:
**31.01.90 Patentblatt 90/5**

(84) Benannte Vertragsstaaten:
**AT BE DE FR GB IT NL SE**

(56) Entgegenhaltungen:
**EP-A- 0 000 317**
**FR-A- 2 558 010**
**GB-A- 2 083 284**

**IEDM - INTERNATIONAL ELECTRON DEVICES MEETING, Washington, DC, 8.-10. Dezember 1980, Technical Digest, Seiten 827-830, New York, US; B.C. LEUNG et al.: "Refractory metal silicide/N+ polysilicon in CMOS/SOS"**

(73) Patentinhaber: **Siemens Aktiengesellschaft, Wittelsbacherplatz 2, D-8000 München 2(DE)**

(72) Erfinder: **Gierisch, Heike, Dipl.-Phys., Raiffeisenstrasse 74, D-8044 Unterschleissheim(DE)**
Erfinder: **Neppl, Franz, Dr., St.-Quirin-Platz 6, D-8000 München 90(DE)**

**EP 0 224 199 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Verfahren zum Herstellen von p- und n-Kanal-MOS-Transistoren enthaltenden hochintegrierten Schaltungen (CMOS), bei dem die Gateelektroden aus Doppelschichten aus hochschmelzenden Metallsiliziden und polykristallinem Silizium bestehen und die Dotierung der polykristallinen Siliziumschicht durch Ausdiffusion aus der Metallsilizidschicht erfolgt und bei dem die Herstellung der aktiven Transistorbereiche, der Kanalzonen, der Source/Drain-Zonen, der Gateelektroden sowie die Herstellung der Leiterbahnebenen nach bekannten Verfahrensschritten der Halbleitertechnologie durchgeführt werden.

Ein solches Verfahren ist beispielsweise aus der am 11.12.1985 veröffentlichten europäischen Patentanmeldung 0 163 871 bekannt (Artikel 54 (3) E.P.Ü.).

Die immer weitergehende Erhöhung der Packungsdichte und die resultierende Verkleinerung der Strukturen läßt Kurzkanal-Effekte bei Transistoren immer wichtiger werden, so zum Beispiel "punch through"-Effekte vor allem beim p-Kanal-Transistor oder "hot electron"-Effekte vor allem beim n-Kanal-Transistor. Die Dotierverhältnisse im Kanalbereich beeinflussen wesentlich die Kurzkanaleigenschaften der Transistoren.

Mit Gatematerialien wie Tantalsilizid oder $p^+$-Polyzid, die eine größere Austrittsarbeit haben als $n^+$-Polyzid (das sind Doppelschichten aus Metallsilizid und poly kristallinem Silizium), kann unter Beibehaltung der Einsatzspannung die Kanaldotierung beim n-Kanal-Transistor und die Kompensation im Kanalbereich des p-Kanal-Transistor verringert werden. Auf diese Weise werden kurze Transistoren mit Längen um 1 µm mit guten Kurzkanaleigenschaften realisierbar. Eine geringere Kompensation im Kanalbereich des p-Kanal-Transistors vermindert wegen der verkleinerten Raumladungszone den "punch through". Die niedrigere Kanaldotierung im n-Kanal-Transistor verringert "hot electron"-Effekte, wie zum Beispiel den Substratstrom oder die Injektion von Ladungsträgern ins Gateoxid und erhöht die Beweglichkeit der Ladungsträger (nähere Einzelheiten siehe Aufsatz von Parrillo et. al. im IEDM Techn. Digest 15.6 (1984), Seiten 418 bis 422). Allerdings verschlechtern sich durch die niedrigere Kanaldotierung die Kurzkanaleigenschaften.

Aus der europäischen Patentanmeldung 0 135 163 ist ein Verfahren zur Herstellung von hochintegrierten CMOS-schaltungen bekannt, bei dem durch die Verwendung von Tantalsilizid als Gatematerial eine symmetrische Einsatzspannung der n- und p-Kanal-Transistoren mit Gateoxiddicken von etwa 20 nm von etwa ± 0,7 V mit einer einzigen, verringerten Kanalimplantationsdosis eingestellt werden kann.

Eine weitere Verbesserung für den p-Kanal-Transistor bietet, wie aus der eingangs genannten europäischen Patentanmeldung 0 163 871 zu entnehmen ist, die Verwendung von $n^+$-Polyzid für den n-Kanal-Transistor und $p^+$-Polyzid für den p-Kanal-Transistor, wobei hier keine Verschlechterung der n-Kanal-Transistor-Eigenschaften in Kauf genommen werden muß. Wegen der um 1 Volt unterchiedlichen Austrittsarbeit des $p^+$-Polyzids gegenüber dem $n^+$-Polyzid kann hier beim p-Kanal-Transistor für Gateoxid-Dicken von etwa 20 nm die Kompensation des Kanalbereichs ganz entfallen, so daß die Abhängigkeit der Einsatzspannung von der Kanallänge ähnlich gut wird wie bei den n-Kanal-Transistoren mit $n^+$-Polyzid-Gate.

Sollen jedoch sowohl die Kurzkanaleigenschaften des p-Kanal-Transistors als auch die Spannungsfestigkeit des n-Kanal-Transistors verbessert werden und die Polysilizium/Gateoxid-Grenzfläche erhalten bleiben, so bietet sich die Verwendung von $p^+$-Polysilizium oder $p^+$-Polyzid an. Bei den üblichen Temperaturbelastungen im CMOS-Prozeß zeigen aber die nach den bekannten Verfahren hergestellten $p^+$-Polysiliziumschichten und $p^+$-Polyzid-Schichten Bor-Penetration-Effekte, wenn nicht aufwendige Gegenmaßnahmen ergriffen werden, wie zum Beispiel die Verwendung von nitridiertem Gateoxid, wie sie zum Beispiel in einem Aufsatz von S. S. Wong et. al. aus dem J. Electrochem. Soc. Vol. 130.5 (1983), auf den Seiten 1139 bis 1144, beschrieben ist.

Aufgabe der Erfindung ist es, ein Verfahren zur Herstellung von p- und n-Kanal-MOS-Transitoren enthaltenden hochintegrierten Schaltungen anzugeben, bei dem die bei Temperaturbelastungen auftretende, durch die Verwendung von bordotierten Polyzid-Gates bedingte Bor-Penetration sicher vermieden wird und in bezug auf Kurzkanaleigenschaften der p-Kanal-Transistoren und Spannungsfestigkeit der n-Kanal-Transistoren optimale CMOS-Schaltungen entstehen.

Diese Aufgabe wird bei einem Verfahren der eingangs genannten Art dadurch gelöst, daß im Prozeßverlauf nach der Herstellung des Gateoxids im Gatebereich der p- und n-Kanal-Transistoren

a) die aus undotierem polykristallinem Silizium bestehende Schicht auf der mit der Gateoxidschicht versehenen Substratoberfläche abgeschieden wird,

b) darauf die Metallsilizidschicht aufgebracht wird,

c) die Doppelschicht aus polykristallinem Silizium und Metallsilizid mit einer, die spätere Source/Drain-Implantation für die n-Kanal-MOS-Transistoren maskierenden Schicht versehen wird,

d) Bor-Atome durch ganzflächige Ionenimplantation in die Metallsilizidschicht eingebracht werden,

e) eine Hochtemperaturbehandlung durchgeführt wird, wobei eine Ausdiffusion der Bor-Ionen aus der Metallsilizidschicht in die polykristalline Siliziumschicht stattfindet und die Doppelschicht kristallisiert wird und

f) die mit der Maskierungsschicht versehene Doppelschicht nach Durchführung einer Photolacktechnik zu Gate-Elektroden strukturiert wird.

Durch das Verfahren nach der Lehre der Erfindung ist die Möglichkeit gegeben, $p^+$-Polyzidgates herzustellen, welche nach den in der CMOS-Technologie üblichen Temperaturbelastungen keinen Bor-Penetration-Effekt zeigen.

Die Integration in den Standard-CMOS-Prozeß wird durch drei wenig aufwendige und vor allem unkritische Schritte erreicht, nämlich a) mit einer ganzflächigen Bor-Ionen-Implantation, b) der Abscheidung einer Maskierschicht und c) der gemeinsamen Strukturierung der Maskierschicht und der Gateebene. Mit diesem $p^+$-Polyzid und einer verringerten bzw. ganz wegfallenden Kanalimplantation können Einsatzspannungen von etwa ± 0,7 V erreicht werden. Gleichzeitig können die Kanallängen-Abhängigkeit der Einsatzspannung des p-Kanal-Transistors verbessert und beim n-Kanal-Transistor "hot electron"-Effekte verringert und die effektive Beweglichkeit der Ladungsträger erhöht werden.

Weitere Ausgestaltungen der Erfindung ergeben sich aus den Unteransprüchen.

Im nachfolgenden wird anhand der Figuren 1 bis 6 der Teil des CMOS-Prozesses, der die erfindungswesentlichen Verfahrensschritte betrifft und die dadurch erzielten Ergebnisse anhand von Meßdiagrammen noch näher beschrieben. Dabei zeigen

die Figuren 1 und 2 im Schnittbild die erfindungswesentlichen Verfahrensschritte,

die Figur 3 einen Vergleich in der C (U)-Abhängigkeit der verschiedenen Gatematerialien,

die Figur 4 die Bor-Penetration bei $p^+$-Polysilizium,

die Figur 5 den Einfluß der Maskierschicht gegen die Phosphor-Source/Drain-Implantation und

die Figur 6 die Drainstrom-Abhängigkeit von der Gatespannung $U_{GS}$ eines p-Kanal-Transistors mit $p^+$-Polyzid.

Figur 1: Der CMOS-Prozeß wird standardmäßig bis zum Gateoxid 2 (25 nm) auf dem, mit den Feldoxidbereichen 3 versehenen Substrat 1 gefahren. Die Kanalimplantation muß entsprechend der Austrittsarbeit des verwendeten $p^+$-Polyzids für die jeweilig einzustellende Einsatzspannung angepaßt werden. Anschließend werden für die Gate-Ebene 100 nm undotiertes Polysilizium 4, 200 nm Tantalsilizid 5 und eine Maskierschicht 6 zum Beispiel aus Siliziumoxid abgeschieden, die das Polyzid 4, 5 vor der späteren Phosphor-Source/Drain-Implantation abschirmen soll, um eine Umdotierung des Gates zu verhindern. Wird als Maskierschicht 6 ein aus Tetraethylorthosilikat durch thermische Zersetzung hergestelltes $SiO_2$ verwendet, so sollte die Oxid-Dicke 6 über dem Polyzid 4, 5 so gewählt werden, daß nach dem späteren Abscheiden eventueller Spacer-Schichten eine etwa 200 nm dicke Oxidschicht 6 entsteht. Danach folgt eine ganzflächige Bor-Ionenimplantation (siehe Pfeile 7) mit einer Energie und Dosis von zum Beispiel 40 keV und $5 \times 10^{15}$ $cm^{-2}$ in die Tantalsilizidschicht 5. Die nachfolgende Tantalsilizid-Temperung bei zum Beispiel 900°C in ein bis zwei Stunden dient nun auch zur Dotierung der polykristallinen Siliziumschicht 4 durch Ausdiffusion des Bor aus der Tantalsilizidschicht 5.

Figur 2: Anschließend wird das so erzeugte $p^+$-Polyzid 4, 5 zusammen mit der Maskierschicht 6 mit Hilfe einer Photolacktechnik (nicht abgebildet) zur Gateelektrode strukturiert, wobei zuerst die Maskierschicht ($SiO_2$) durch reaktives Ionenätzen in Trifluormethan und Sauerstoff und anschließend das Polyzid durch reaktives Ionenätzen in Bortrichlorid und Chlor geätzt wird. Der weitere Verlauf entspricht dann wieder dem Standard-CMOS-Prozeß.

Wie aus Figur 3 zu entnehmen ist, zeigen Messungen an MOS-Kondensatoren mit $p^+$-PolyzidGate ohne Kanalimplantation aufgrund der Flachbandspannungsverschiebung von etwa 1 V zu positiveren Spannungen gegenüber $n^+$-Polyzid, daß die in Figur 1 und 2 beschriebene Dotierung des polykristallinen Silizium bis an die Grenzfläche zum Gateoxid realisiert werden kann. Zum Vergleich ist auch die C (U)-Abhängigkeit für $TaSi_2$ mitaufgetragen worden.

Aus Figur 4 wird ersichtlich, daß bei $p^+$-Polyzid, welches mit dem erfindungsgemäßen Verfahren hergestellt wurde (Kurve I) im Gegensatz zum normalen $p^+$-polykristallinem Silizium (Kurve II) auch nach einer Temperaturbelastung von 180 Minuten bei 900°C noch kein Bor-Penetration-Effekt auftritt.

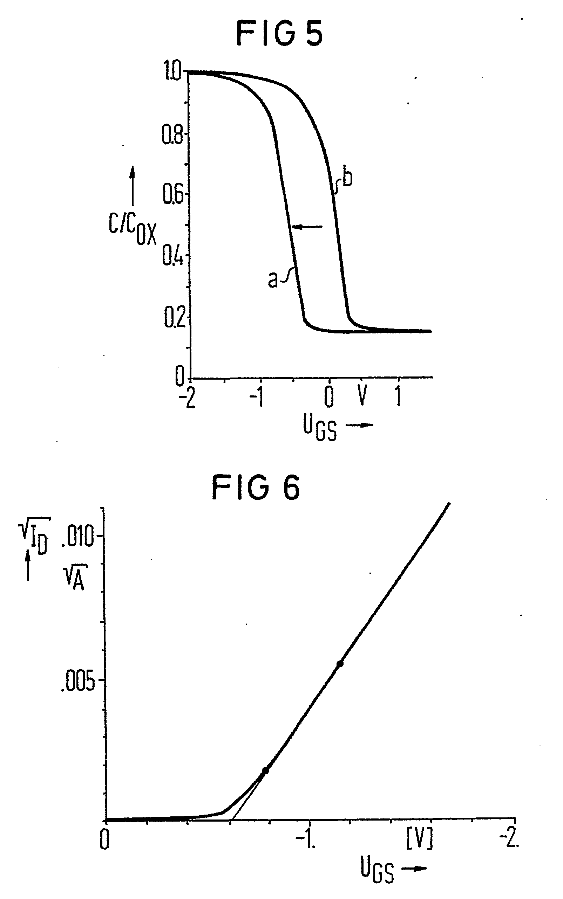

Figur 5 zeigt den Einfluß der Maskierschicht bei der Phosphor-Source/Drain-Implantation auf die Flachbandspannung des MOS-Kondensators. Mit nur 100 nm TEOS (= Oxid aus Tetraethylorthosilikat) als Maskierung tritt aufgrund von Umdotierung im polykristallinen Silizium eine unerwünschte Flachbandspannungs-Verschiebung zu negativen Spannungen auf (Kurve a), die mit einer 200 nm dicken TEOS-Maskierschicht nicht sichtbar wird (Kurve b). Das bedeutet, daß ein Einfluß der Phosphor-Source/Drain-Implantation auf die Einsatzspannung der Transistoren sicher verhindert werden kann.

Figur 6 zeigt die Drainstrom ($I_{DS}$)-Abhängigkeit des p-Kanal-Transistors von der Gatespannung ($U_{GS}$). Aufgetragen ist als Ordinate die Wurzel des Drainstromes

$$\sqrt{I_{DS}}$$

über der Gatespannung $U_{GS}$, womit sich die Einsatzspannung des Transistors leicht bestimmen läßt. Die ermittelte Einsatzspannung dieser Transistoren beträgt- ohne kompensierende Kanalimplantation - 0,6 V.

**Patentansprüche**

1. Verfahren zum Herstellen von p- und n-Kanal-MOS-Transistoren enthaltenden hochintegrierten Schaltungen (CMOS), bei dem die Gate-Elektroden aus Doppelschichten aus hochschmelzenden Metallsiliziden und polykristallinem Silizium bestehen und die Dotierung der polykristallinen Siliziumschicht durch Ausdiffusion aus der Metallsilizidschicht erfolgt und bei dem die Herstellung der aktiven Transistorbereiche, der Kanalzonen, der Source/ Drain-Zonen, der Gate-Elektroden sowie die Herstellung der Leiterbahnebenen nach bekannten Verfahrensschritten der Halbleitertechnologie durchgeführt werden, wobei im Prozeßverlauf, nach der Herstellung des Gateoxids (2) im Gatebereich der p- und n-Kanal-Transistoren,

a) die aus undotiertem polykristallinem Silizium bestehende Schicht (4) auf der mit der Gateoxidschicht (2) versehenen Substratoberfläche abgeschieden wird,
b) darauf die Metallsilizidschicht (5) aufgebracht wird,
c) die Doppelschicht (4, 5) aus polykristallinem Silizium und Metallsilizid mit einer die spätere Source/Drain-Implantation für die n-Kanal-MOS-Transistoren und eine Umdotierung des Gates verhindernden maskierenden Schicht (6) versehen wird,
d) Bor-Atome durch ganzflächige Ionenimplantation (7) in die Metallsilizidschicht (5) eingebracht werden,
e) eine Hochtemperaturbehandlung durchgeführt wird, wobei eine Ausdiffusion der Bor-Ionen aus der Metallsilizidschicht (5) in die polykristalline Siliziumschicht (4) stattfindet und die Doppelschicht (4, 5) kristallisiert wird und
f) die mit der Maskierungsschicht (6) versehene Doppelschicht (4, 5) nach Durchführung einer Photolacktechnik zu Gateelektroden strukturiert wird.

2. Verfahren nach Anspruch 1, **dadurch gekennzeichnet**, daß als Metallsilizid (5) Tantalsilizid verwendet wird.

3. Verfahren nach Anspruch 1 und/oder 2, **dadurch gekennzeichnet**, daß als Maskierschicht (6) eine $SiO_2$-Schicht verwendet wird.

4. Verfahren nach Anspruch 3, **dadurch gekennzeichnet**, daß durch thermische Zersetzung von Tetraethylorthosilikat hergestelltes $SiO_2$ (6) (TEOS) in einer Schichtdicke von mindestens 100 nm verwendet wird.

5. Verfahren nach einem der Ansprüche 1 bis 4, **dadurch gekennzeichnet**, daß eine Doppelschicht (4, 5) aus 100 nm undotiertem, polykristallinem Silizium (4) und 200 nm Tantalsilizid (5) verwendet wird.

6. Verfahren nach einem der Ansprüche 1 bis 5, **dadurch gekennzeichnet**, daß die Bor-Ionenimplantation (7) nach Verfahrensschritt d) mit einer Dosis und Energie von $5 \times 10^{15}$ $cm^{-2}$ und 40 keV durchgeführt wird.

7. Verfahren nach einem der Ansprüche 1 bis 6, **dadurch gekennzeichnet**, daß die Hochtemperaturbehandlung nach Verfahrensschritt e) bei 900°C mit einer Zeitdauer von mindestens 1 und maximal 2 Stunden durchgeführt wird.

## Claims

1. Process for producing highly integrated circuits (CMOS) containing p- and n-channel MOS transistors, in which process the gate electrodes consist of double layers of high-melting metal silicides and polycrystalline silicon, and the doping of the polycrystalline silicon layer takes place by outdiffusion from the metal silicide layer, and in which process production of the active transistor regions, the channel regions, the source/drain regions and the gate electrodes, as well as the production of the conductor track planes, is carried out in accordance with known process steps of semiconductor technology, wherein during the course of the process, after the production of the gate oxide (2) in the gate region of the p- and n-channel transistors,
a) the layer (4) consisting of undoped polycrystalline silicon is deposited on the substrate surface provided with the gate oxide layer (2),
b) the metal silicide layer (5) is applied thereon,
c) the double layer (4, 5) of polycrystalline silicon and metal silicide is provided with a layer (6) masking the later source/drain implantation for the n-channel MOS transistors and preventing a redoping of the gate,
d) boron atoms are introduced into the metal silicide layer (5) by means of whole-area ion implantation (7),
e) a high-temperature treatment is carried out, an out-diffusion of the boron ions taking place from the metal silicide layer (5) into the polycrystalline silicon layer (4), and the double layer (4, 5) being crystallised and
f) the double layer (4, 5) provided with the masking layer (6) is structured after carrying out a photoresist technique to form gate electrodes.

2. Process according to Claim 1, characterized in that tantalum silicide is used as the metal silicide (5).

3. Process according to Claim 1 and/or 2, characterized in that an $SiO_2$ layer is used as the masking layer (6).

4. Process according to Claim 3, characterized in that $SiO_2$ (6) produced by thermal decomposition of tetraethyl orthosilicate (TEOS) is used in a layer thickness of at least 100nm.

5. Process according to one of Claims 1 to 4, characterized in that a double layer (4, 5) of 100nm undoped, polycrystalline silicon (4) and 200nm tantalum silicide (5) is used.

6. Process according to one of Claims 1 to 5, characterized in that the boron ion implantation (7) in accordance with process step d) is carried out with a dose of $5 \times 10^{15}$ $cm^{-2}$ and an energy of 40 keV.

7. Process according to one of Claims 1 to 6, characterized in that the high-temperature treatment in accordance with process step e) is carried out at 900°C for a period of at least 1 and at most 2 hours.

## Revendications

1. Procédé pour fabriquer des circuits à haute densité d'intégration (CMOS), contenant des transistors MOS à canal p et n, et selon lequel les électrodes de grilles sont constituées par des couches doubles formées de siliciures métalliques à point de fusion élevé et de silicium polycristallin et le dopage de la couche de silicium polycristallin est réalisé par diffusion à partir de la couche de siliciure métallique, et selon lequel la fabrication des régions actives des transistors, des zones de canal, des zones de source/drain et des électrodes de grille ainsi que la fabrication des plans des voies conductrices sont exécutées selon des étapes opératoires connues de la technologie des semiconducteurs, et selon lequel, lors du déroulement du procédé, après la

fabrication de l'oxyde de grille (2) dans la région de grille des transistors à canal p et n,

a) on dépose la couche (4) constituée par du silicium polycristallin non dopé, sur la surface du substrat pourvue de la couche d'oxyde de grille (2),

b) on dépose sur ladite couche la couche de siliciure métallique (5),

c) on dépose sur la couche double (4, 5) constituée par du silicium polycristallin et un siliciure métallique, une couche (6) réalisant un masquage pour l'implantation ultérieure de la source/du drain pour les transistors MOS à canal n et empêchant une modification du dopage de la grille,

d) on introduit des atomes de bore dans la couche de siliciure métallique (5) au moyen d'une implantation ionique (7) exécutée sur toute la surface,

e) on met en œuvre un traitement à haute température, lors duquel il se produit une diffusion des ions de bore depuis la couche de siliciure métallique (5) dans la couche de silicium polycristallin (4) et la couche double (4, 5) passe à l'état cristallisé, et

f) après la mise en œuvre d'une technique utilisant une laque photosensible, on structure la couche double (4, 5) pourvue de la couche de masquage (6), pour former des électrodes de grille.

2. Procédé suivant la revendication 1, caractérisé par le fait qu'on utilise comme siliciure métallique (5), du siliciure de tantale.

3. Procédé suivant la revendication 1 et/ou 2, caractérisé par le fait qu'on utilise, comme couche de masquage (6), une couche de $SiO_2$.

4. Procédé suivant la revendication 3, caractérisé par le fait qu'on utilise du $SiO_2$ (6) (TEOS), fabriqué par dissociation thermique d'orthosilicate de tétraéthyle et possédant une épaisseur de couche égale à au moins 100 nm.

5. Procédé suivant l'une des revendications 1 à 4, caractérisé par le fait qu'on utilise une couche double (4, 5) formée de 100 nm de silicium polycristallin non dopé (4) et de 200 nm de siliciure de tantale (5).

6. Procédé suivant l'une des revendications 1 à 5, caractérisé par le fait qu'on exécute l'implantation d'ions de bore (7) lors de l'étape opératoire (d) avec une dose égale à $5 \times 10^{15}$ $cm^{-2}$ et une énergie égale à 40 keV.

7. Procédé suivant l'une des revendications 1 à 6, caractérisé par le fait qu'on exécute le traitement à haute température lors de l'étape opératoire (e) à 900°C pendant une durée égale à au moins 1 et au maximum 2 heures.

FIG 1

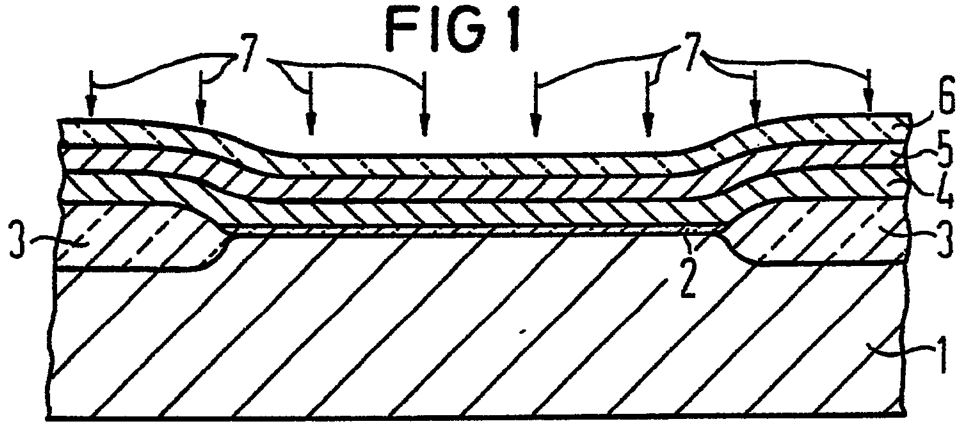


FIG 2

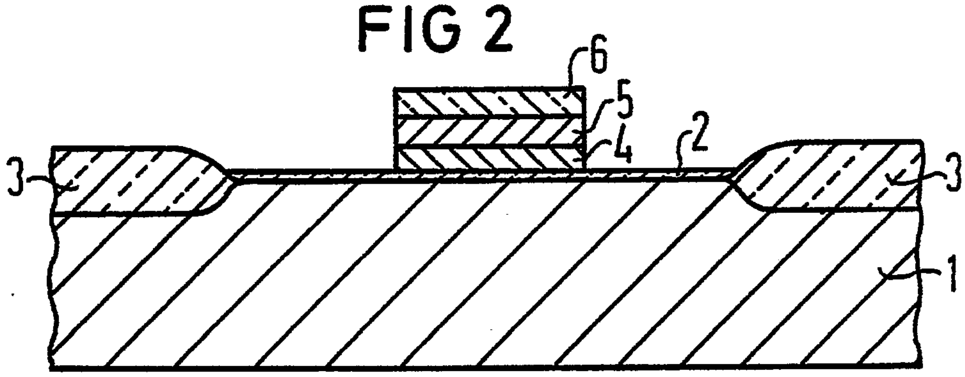


FIG 3

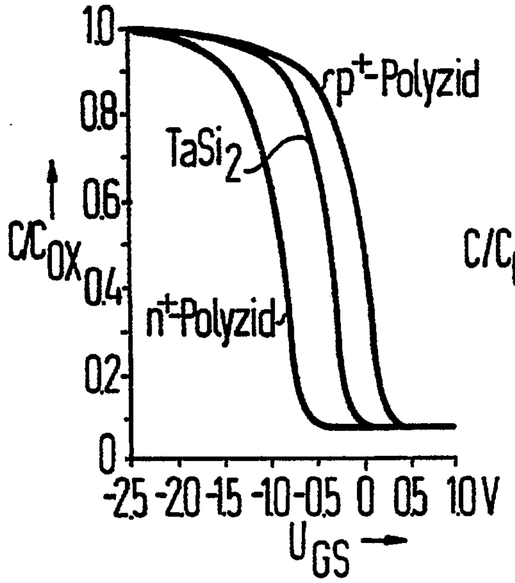


FIG 4

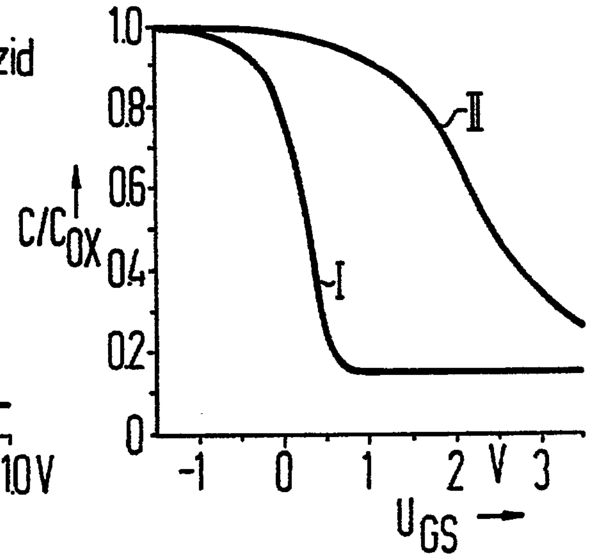

FIG 5

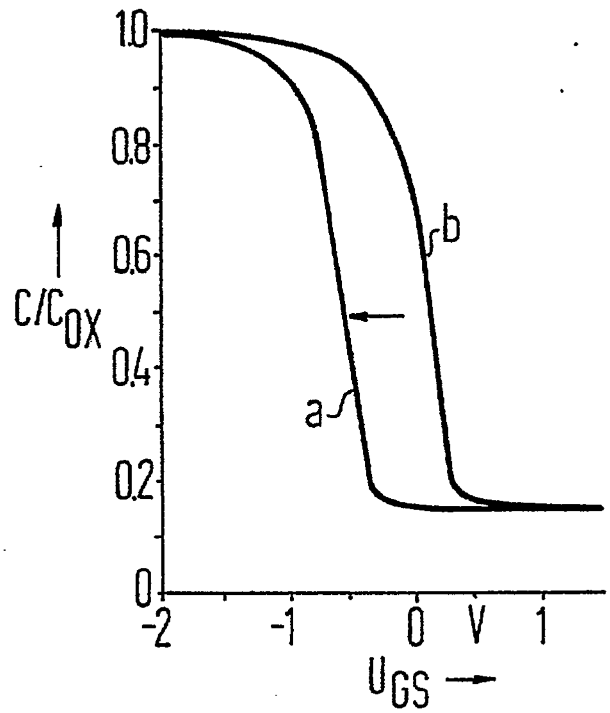


FIG 6